# EUROPEAN PATENT APPLICATION

(11) **EP 3 309 825 A1**
(43) Date of publication of application: **18.04.2018**
(21) Application number: 17196521.3
(22) Date of filing: 16.10.2017
(51) Int. Cl.: H01L 21/8238, H01L 21/28, H01L 21/30, H01L 29/66

(54) **SEMICONDUCTOR STRUCTURES AND FABRICATION METHODS THEREOF**

(30) Priority: 17.10.2016 CN 201610903470
(71) Applicant: Semiconductor Manufacturing International Corporation (Shanghai), Shanghai 201203 (CN); Semiconductor Manufacturing International Corporation (Beijing), Beijing 100176 (CN)
(72) Inventor: LI, Yong, Shanghai, 201203 (CN)
(74) Representative: Klunker IP Patentanwälte PartG mbB

(57) **Abstract**

A method for fabricating a semiconductor structure includes providing a base structure including an NMOS region (I), forming an interlayer dielectric layer (204) on the base structure with a plurality of openings formed in the NMOS region through the interlayer dielectric layer, forming a high-k dielectric layer (100) on a bottom and sidewall surfaces of each opening of the NMOS region, forming an N-type work function layer (209) on the high-k dielectric layer in each opening of the NMOS region, forming a diffusion barrier layer (301) on the N-type work function layer, performing a hydrogenation process (300) on the diffusion barrier layer, and forming a metal gate electrode on the diffusion barrier layer to fill up each opening in the NMOS region. The disclosed method and semiconductor structure improve the ability of the barrier layer to protect the N-type work function layer, and thus improve the electrical performance of the semiconductor device.

## Description

### CROSS-REFERENCES TO RELATED APPLICATIONS

This application claims the priority of Chinese Patent Application No. CN201610903470.8, filed on October 17, 2016.

### TECHNICAL FIELD

The present invention generally relates to the field of semiconductor fabrication technology and, more particularly, relates to semiconductor structures and fabrication methods thereof.

### BACKGROUND

The major semiconductor devices for integrated circuits (ICs), especially for very-large scale integrated (VLSI) circuits, include metal-oxide-semiconductor field-effect transistors (MOSFETs). With the continuous development of IC manufacturing technology, the technical nodes of semiconductor devices continue to decrease, and the geometrical dimensions of semiconductor devices become smaller and smaller following the Moore's law. When the reduction of the dimensions of semiconductor devices reaches a certain level, various secondary effects due to approaching the physical limits of semiconductor devices begin to emerge, and thus further scaling down the feature size of semiconductor devices becomes more and more difficult. Among all the problems in the field of semiconductor manufacturing, the most challenging one is to solve the large leakage current issue in semiconductor devices. Specifically, a large leakage current in a semiconductor device is mainly caused by the continuous decrease in the thickness of the conventional dielectric layer in the semiconductor device.

Currently, a method to solve the problem is to use a high-k material to replace the conventionally-used SiO₂ as the gate dielectric material and also use a metal material as the gate electrode material to avoid Fermi level pinning between the high-k material and the conventional gate electrode material and also avoid boron penetration. Such a gate structure using a high-k material to form the gate dielectric layer and a metal material to form the gate electrode is known as a high-k metal gate (HKMG). The introduction of HKMG reduces the leakage current in semiconductor structures.

Although the electrical performance of semiconductor structures has been somewhat improved by introducing the HKMG, the electrical performance of semiconductor structures may still need to be improved.

### BRIEF SUMMARY

It is an object of the present invention to provide a semiconductor structure and a fabrication method thereof which may solve one or more problems set forth above and other problems in the art, in particular wherein the electrical performance of the semiconductor structures may still be improved.

The object is achieved by the features of the respective independent claims. Further embodiments are defined in the respective dependent claims.

A first aspect of the present invention provides a method for fabricating a semiconductor structure. The method for fabricating the semiconductor structure includes providing a base structure including an N-type metal-oxide-semiconductor (NMOS) region, forming an interlayer dielectric layer on the base structure with a plurality of openings formed in the NMOS region through the interlayer dielectric layer, forming a high-k dielectric layer on a bottom and sidewall surfaces of each opening of the NMOS region, forming an N-type work function layer on the high-k dielectric layer in each opening of the NMOS region, forming a diffusion barrier layer on the N-type work function layer, performing a hydrogenation process on the diffusion barrier layer, and forming a metal gate electrode on the diffusion barrier layer to fill up each opening in the NMOS region.

Preferably, the metal gate electrode contains fluorine ions.

Preferably, the hydrogenation process includes an annealing process.

Preferably, an environmental gas of H2 or D2 is used in the annealing process.

Preferably, an anneal temperature used in the annealing process is in a range of approximately 100 °C to 500 °C.

Preferably, the hydrogenation process is a hydrogen ion implantation process.

Preferably, an implantation depth of the hydrogen ion implantation process is approximately 1/3 to 2/3 of a thickness of the diffusion barrier layer.

Preferably, an implantation dose during the hydrogen ion implantation process is in a range of approximately 1E14 atom/cm2 to 3E16 atom/cm2.

Preferably, the hydrogenation process includes using hydrogen plasma to treat the diffusion barrier layer.

Preferably, the hydrogen plasma treatment uses process parameters including: a treatment chamber pressure in a range of approximately 1 Torr to 100 Torr; and a treatment chamber temperature smaller than or equal to 200 °C.

Preferably, the diffusion barrier layer is made of one or more of TiN and TaN.

Preferably, the N-type work function layer is made of at least one of TiAl, TiAlN, TiAlC, and AlN.

Preferably, a thickness of the diffusion barrier layer is in a range of approximately 10 Å to 60 Å.

Preferably, prior to forming the diffusion barrier layer, an oxygenation process is performed on the N-type work function layer to form an alumina layer on the N-type work function layer.

Preferably, the base structure further includes a P-type metal-oxide-semiconductor (PMOS) region, and the method further includes: forming a plurality of openings in the PMOS region through the interlayer dielectric layer; forming a high-k dielectric layer on a bottom and sidewall surfaces of each opening in the PMOS region; forming a P-type work function layer above the high-k dielectric layer in each opening of the PMOS region; and forming a metal gate electrode on the P-type work function layer to fill up each opening in the PMOS region.

Preferably, forming the high-k dielectric layer, the P-type work function layer, the diffusion barrier layer, the N-type work function layer, and the metal gate electrode includes: forming a high-k dielectric layer on the bottom and the sidewall surfaces of each opening in the NMOS region and also on the bottom and the sidewall surfaces of each opening in the PMOS region; forming a first work function layer on the high-k dielectric layer; removing the portion of the first work function layer formed in each opening of the NMOS region to expose a portion of the high-k dielectric layer in the opening; forming a second work function layer on the portion of the first work function layer in each opening of the PMOS region, wherein the portion of the second work function layer and the portion of the first work function layer formed in the opening of the PMOS region together serve as the P-type work function layer; forming the N-type work function layer on the portion of the high-k dielectric layer exposed in each opening of the NMOS region; forming the diffusion barrier layer on the N-type work function layer; and after performing the hydrogenation process on the diffusion barrier layer, forming a metal gate electrode to fill each opening in the NMOS region or in the PMOS region.

Preferably, the second work function layer is also formed above the high-k dielectric layer in each opening of the NMOS region to protect the portion of the high-k dielectric layer in each opening of the NMOS region.

Preferably, the N-type work function layer is formed on a top surface of the second work function layer.

Preferably, the N-type work function is also above the P-type work function layer.

Preferably, the first work function layer is made of one or more of TiN, TaN, TaSiN, and TiSiN.

Preferably, the second work function layer is made of one or more of TiN and TaN.

Preferably, a thickness of the first work function layer is in a range of approximately 15 Å to 40 Å.

Preferably, a thickness of the second work function layer is in a range of approximately 15 Å to 70 Å.

A second aspect of the present invention provides a semiconductor structure. The semiconductor structure includes a base structure including an NMOS region. An interlayer dielectric layer is formed on the base structure with a plurality of openings formed in the NMOS region through the interlayer dielectric layer. The semiconductor structure also includes a high-k dielectric layer formed on a bottom and sidewall surfaces of each opening of the NMOS region, an N-type work function layer formed on the high-k dielectric layer in each opening of the NMOS region, a diffusion barrier layer formed on the N-type work function layer, and hydrogenated through a hydrogenation process, and a metal gate electrode formed on the hydrogenated diffusion barrier layer to fill up each opening in the NMOS region.

Preferably, the hydrogenated diffusion barrier layer is made of hydrogen-containing TiN or hydrogen-containing TaN.

Preferably, a thickness of the diffusion barrier layer is in a range of approximately 10 Å to 60 Å.

Preferably, the base structure further includes a P-type metal-oxide-semiconductor (PMOS) region.

Preferably, the interlayer dielectric layer further includes a plurality of openings there-through and formed in the PMOS region.

Preferably, a high-k dielectric layer is formed on a bottom and sidewall surfaces of each opening in the PMOS region.

Preferably, a P-type work function layer is formed above the high-k dielectric layer in each opening of the PMOS region.

Preferably, a metal gate electrode is formed on the P-type work function layer to fill up each opening in the PMOS region.

The semiconductor structure according to the second aspect of the present invention may be obtained by a method according to the first aspect of the present invention.

Other aspects of the present invention can be understood by those skilled in the art in light of the description, the claims, and the drawings of the present invention.

### BRIEF DESCRIPTION OF THE DRAWINGS

The following drawings are merely examples for illustrative purposes according to various disclosed embodiments and are not intended to limit the present invention.
FIGS. 1-12 illustrate schematic cross-section views of semiconductor structures at certain stages of an exemplary fabrication process consistent with various disclosed embodiments in the present invention; and
FIG. 13 illustrates a flowchart of an exemplary fabrication method for a semiconductor structure consistent with various disclosed embodiments in the present invention.

### DETAILED DESCRIPTION

Reference will now be made in detail to exemplary embodiments of the invention, which are illustrated in the accompanying drawings. Wherever possible, the same reference numbers will be used throughout the drawings to refer to the same or like parts.

When forming semiconductor devices, in order to meet the requirements for improving the threshold voltages of N-type metal-oxide-semiconductor (NMOS) transistors and/or P-type metal-oxide-semiconductor (PMOS) transistors, different metal materials may be used to form the work function layers in the gate structures of the NMOS transistors and/or the PMOS transistors. The materials used to form N-type work function layers are known as N-type work function materials and the materials used to form P-type work function layers are known as P-type work function materials. For an NMOS transistor, the metal gate electrode contains ions that are easily diffused into the N-type work function layer. For example, the metal gate electrode may contain F (fluorine) ions, and the diffusion of F ions into the N-type work function layer may cause an increase in the effective work function value of the N-type work function layer. Therefore, a diffusion barrier layer may need to be formed between the N-type work function layer and the metal gate electrode in order to prevent the ions from diffusing into the N-type work function layer.

However, the diffusion barrier layer may not have sufficient ability to prevent the ions in the metal gate electrode from diffusing into the N-type work function layer. In order to further improve the ability of the diffusion barrier layer to block ion diffusion, the thickness of the diffusion barrier layer may be increased.

Usually, the work function value of the diffusion barrier layer is greater than the work function value of the N-type work function layer. Therefore, when the thickness of the diffusion barrier layer is increased, the influence of the diffusion barrier layer on the effective work function value of the gate structure of the NMOS transistor may also become more prominent. In addition, increasing the thickness of the diffusion barrier layer may also result in degraded filling ability of the metal gate electrode, causing undesired effects on the electrical performance of the semiconductor device.

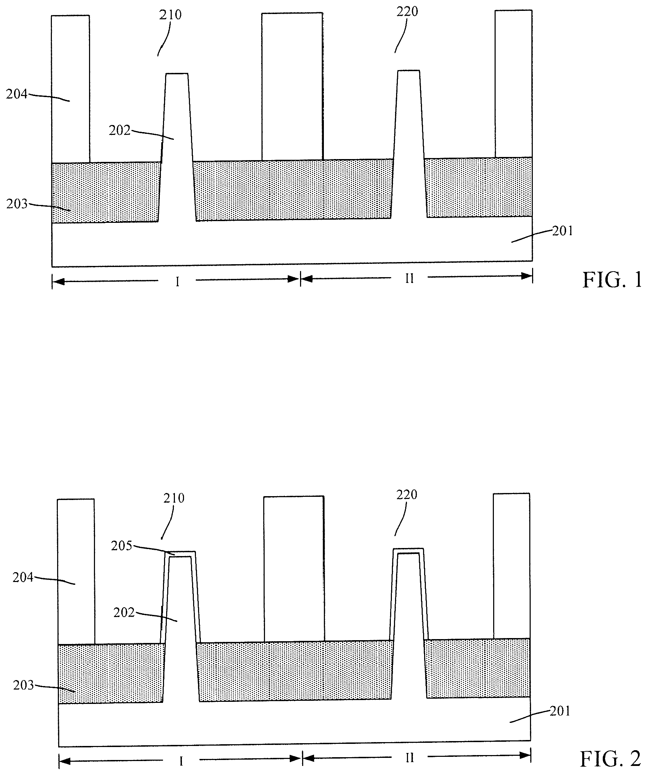

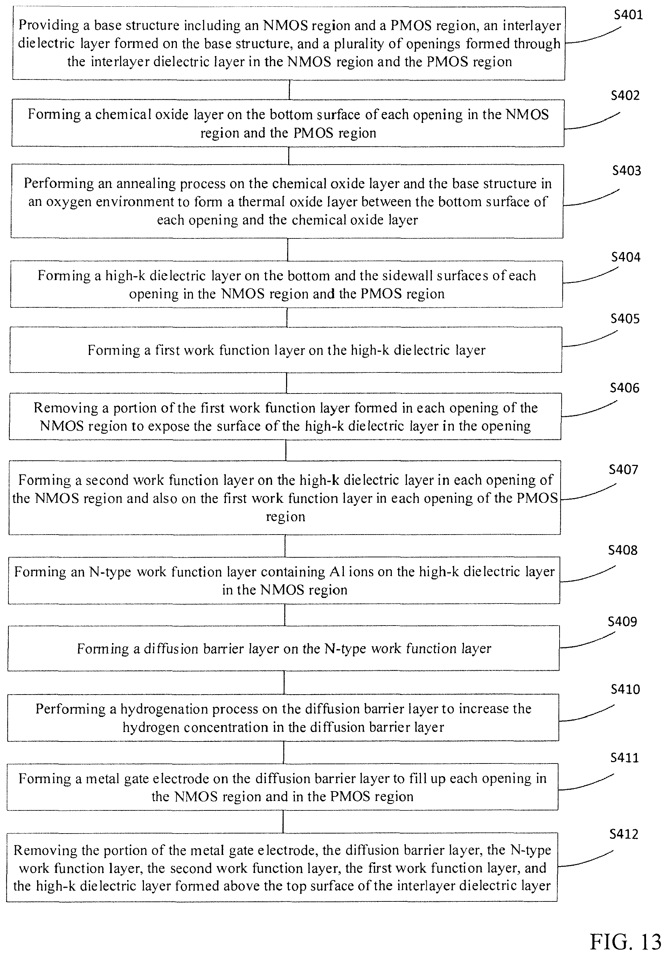

The present invention provides a method for fabricating a semiconductor structure. FIG. 13 illustrates a flowchart of an exemplary fabrication method for a semiconductor structure consistent with various disclosed embodiments in the present invention. FIGS. 1-12 show schematic cross-section views of semiconductor structures at certain stages of the fabrication method.

Referring to FIG. 13, at the beginning of the fabrication process, a base structure including an NMOS region and a PMOS region is provided (S401). FIG. 1 illustrates a schematic cross-section view of a corresponding semiconductor structure.

Referring to FIG. 1, a base structure may be provided. The base structure may include an NMOS region I. An interlayer dielectric layer 204 may be formed on the base structure, and a plurality of openings 210 may be formed through the interlayer dielectric layer 204 in the NMOS region I.

In one embodiment, the semiconductor structure to be formed includes a plurality of fin field-effect transistors (Fin-FETs) and the base structure includes a substrate 201 and a plurality of fin structures 202 formed on the surface of the substrate 201. In other embodiments, the semiconductor structure to be formed may include other types of transistors, including conventional planar MOSFETs, etc.

The substrate 201 may be made of silicon, germanium, SiGe, SiC, GaAs, InAs, or any other appropriate semiconductor material. The substrate 201 may also be made of silicon on insulator (SOI) or germanium on insulator (GOI). The fin structures 202 may be made of Si, Ge, SiGe, SiC, GaAs, InAs, or any other appropriate semiconductor material. In one embodiment, the substrate 201 is made of silicon and the plurality of fin structures 202 are also made of silicon.

The substrate 201 and the plurality of fin structures 202 may be formed by a process including the following steps. First, an initial substrate may be provided. A patterned hard mask layer may then be formed on the surface of the initial substrate. Further, the initial substrate may be etched using the hard mask layer as an etch mask to simultaneously form the substrate 201 and the plurality of fin structures 202. Specifically, the initial substrate after etching may become the substrate 201, and a plurality of protrusions formed on the surface of the substrate 201 may become the fin structures 202.

In one embodiment, the base structure may also include an isolation layer 203 formed on the surface of the substrate 201. The isolation layer 203 may cover a portion of the side surfaces of each fin structure 202, and the top surface of the isolation layer 203 may be lower than the top surfaces of the fin structures 202. The isolation layer 203 may be used as an isolation structure for a plurality of complementary metal-oxide-semiconductor (CMOS) devices. The isolation layer 203 may be made of SiOₓ, SiNₓ, SiON, or any other appropriate material. In one embodiment, the isolation layer 203 is made of SiOₓ.

In one embodiment, the semiconductor device to be formed is a CMOS device including a plurality of CMOS transistors. In other embodiments, the semiconductor device may be other type of device.

In one embodiment, the base structure may also include a PMOS region II. Accordingly, the interlayer dielectric layer 204 may also be formed in the PMOS region II. Moreover, a plurality of openings 220 may be formed through the interlayer dielectric layer 204 in the PMOS region II. Further, although the disclosed semiconductor structure to be formed may include a plurality of NMOS transistors in the NMOS region I and a plurality of PMOS transistors in the PMOS region II, only one NMOS transistor in the NMOS region I and one PMOS transistor in the PMOS region II are described as examples to illustrate the disclosed semiconductor devices and the fabrication methods. In other embodiments, when the formed semiconductor device is an NMOS (or PMOS) device including only a plurality of NMOS (or PMOS) transistors, the base structure may only include an NMOS (or PMOS) region.

Moreover, in one embodiment, the formed semiconductor device includes a plurality of planar transistors, and accordingly, the base structure may be a planar substrate. The planar substrate may be made of silicon, germanium, SiGe, SOI, GOI, glass, Group III-V compounds, or any other appropriate material. The Group III-V compounds may include GaAs, InAs, etc.

Each opening 210 in the NMOS region I may expose a portion of the surface of the base structure in the NMOS region I. In one embodiment, the opening 210 in the NMOS region I exposes a portion of the surface of each fin structure 202 and a portion of the surface of the isolation layer 203. The opening 210 formed in the NMOS region I may provide a processing space for a subsequently-formed first gate structure. Similarly, the opening 220 formed in the PMOS region II may expose a portion of the surface of the base structure in the PMOS region II. In one embodiment, the opening 220 formed in the PMOS region II exposes a portion of the surface of each fin structure 202 and a portion of the surface of the isolation layer 203. The opening 220 formed in the PMOS region II may provide a processing space for a subsequently-formed second gate structure.

A pair of first source/drain doped regions (not shown) may be formed in the corresponding fin structure 202 on the opposite sides of each opening 210 in the NMOS region I along the extending direction (or length direction) of the fin structure 202. Similarly, a pair of second source/drain doped regions (not shown) may be formed in the corresponding fin structure 202 on the opposite sides of each opening 220 in the PMOS region II along the extending direction of the fin structure 202. The type of the doping ions in the first source/drain doped regions may be opposite to the type of the doping ions in the second source/drain doped regions. In one embodiment, the doping ions in the first source/drain doped regions are N-type ions, such as P ions, As ions, Sb ions, etc.; and the doping ions in the second source/drain doped regions are P-type ions, such as B ions, Ga ions, In ions, etc.

The interlayer dielectric layer 204, the opening 210 in the NMOS region I, and the opening 220 in the PMOS region II may be formed by a process including the following steps. First, a first dummy gate structure may be formed on a portion of the surface of the base structure in the NMOS region I. Similarly, a second dummy gate structure may be formed on a portion of the surface of the base structure in the PMOS region II. A first source/drain region may then be formed in the base structure of the NMOS region I on each side of the first dummy gate structure and a second source/drain region may also be formed in the base structure of the PMOS region II on each side of the second dummy gate structure. Further an interlayer dielectric layer 204 may be formed on the surface of the base structure. The interlayer dielectric layer 204 may cover the side surfaces of the first dummy gate structure as well as the side surfaces of the second dummy gate structure. The first dummy gate structure may then be removed to form an opening 210 in the NMOS region I and the second dummy gate structure may also be removed to form an opening 220 in the PMOS region II.

In one embodiment, after forming the interlayer dielectric layer, the opening in the NMOS region, and the opening in the PMOS region, the fabrication process may further include forming an interfacial layer on the bottom of the opening 210 in the NMOS region I and another interfacial layer on the bottom of the opening 220 in the PMOS region II. The interfacial layer in the NMOS region I and the interfacial layer in the PMOS region II may be formed simultaneously through a single fabrication process. In one embodiment, each interfacial layer includes a thermal oxide layer and a chemical oxide layer formed on the thermal oxide layer. In other embodiments, the interfacial layer may have any other appropriate structure.

Returning to FIG. 13, a chemical oxide layer may be formed on the bottom surface of each opening in the NMOS region and the PMOS region (S402). FIG. 2 illustrates a schematic cross-section view of a corresponding semiconductor structure.

Referring to FIG. 2, a chemical oxide layer 205 may be formed on the bottom surface of each opening 210 in the NMOS region I. In one embodiment, the chemical oxide layer 205 may also be formed on the bottom surface of each opening 220 in the PMOS region II. That is, the chemical oxide layer 205 may cover the bottom surface of each opening 210 in the NMOS region I and the bottom surface of each opening 220 in the PMOS region II.

In a subsequent process, an interfacial layer may be formed based on the chemical oxide layer 205. The interfacial layer may be a portion of the subsequently-formed gate structure. For example, the interfacial layer and the subsequently-formed high-k dielectric layer may together form a double-layer structure and serve as the gate dielectric layer of the gate structure. In addition, the interfacial layer may provide a desired interface basis for subsequent formation of the high-k dielectric layer, and thus may improve the quality of the formed high-k dielectric layer and reduce the density of interface states between the high-k dielectric layer and the base structure. As such, undesired effects due to direct contact between the high-k dielectric layer and the base structure may be avoided.

Moreover, in one embodiment, the chemical oxide layer 205 may be formed on the surface of the base structure through a chemical dip method. Specifically, SiOₓ formed by oxidation using the chemical dip method, together with the material used to form the high-k dielectric layer in a subsequent process, may easily form a mixed structure of Hf-Si-O between the chemical oxide layer 205 and the subsequently-formed high-k dielectric layer. Therefore, the condition at the interface between the interfacial layer and the high-k dielectric layer may be improved, and the properties of the subsequently-formed high-k dielectric layer may also be improved.

In one embodiment, the chemical oxide layer 205 may be made of SiOₓ, and the thickness of the chemical oxide layer 205 may be in a range of approximately 2 Å to 20 Å.

In one embodiment, the chemical oxide layer 205 may be formed by a process including the following aspects: a mixed solution of sulfuric acid and hydrogen peroxide may be used during a chemical dip process; the reaction temperature used in the chemical dip process may be in a range of approximately 120 °C to 180 °C; and the volume ratio of sulfuric acid to hydrogen peroxide may be in a range of approximately 1:1 to 5:1.

In another embodiment, the chemical oxide layer 205 may be formed by a process including the following aspects: a mixed solution of ammonia and hydrogen peroxide may be used during the chemical dip process; the reaction temperature used in the chemical dip process may be in a range of approximately 25 °C to 45 °C; and a volume ratio of ammonia to hydrogen peroxide may be in a range of approximately 1:4 to 1:25.

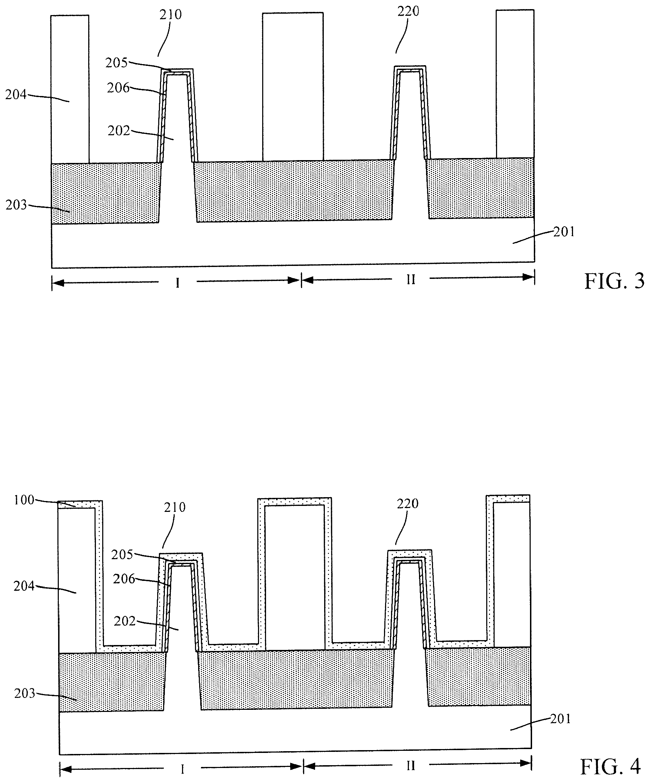

Further, returning to FIG. 13, an annealing process may be performed on the chemical oxide layer and the base structure in an oxygen-containing environment such that a thermal oxide layer may be formed between the bottom surface of each opening and the chemical oxide layer (S403). FIG. 3 illustrates a schematic cross-section view of a corresponding semiconductor structure.

Referring to FIG. 3, an annealing process may be performed on the chemical oxide layer 205 and the base structure in an oxygen-containing environment. After the annealing process, a thermal oxide layer 206 may be formed between the bottom surface of each opening 210 in the NMOS region I and the chemical oxide layer 205.

In one embodiment, the semiconductor structure may also include a plurality of openings 220 formed in a PMOS region II. Accordingly, after the annealing process, the thermal oxide layer 206 may be formed between the bottom surface of each opening 220 in the PMOS region II and the chemical oxide layer 205.

In one embodiment, the thermal oxide layer 206 may be formed between the fin structure 202 and the chemical oxide layer 205. The thermal oxide layer 206 may be tightly in contact with the fin structure 202 such that the properties of the interface between the thermal oxide layer 206 and the fin structure 202 may be desired. In addition, the thermal oxide layer 206 may also be tightly in contact with the chemical oxide layer 205 such that the properties of the interface between the thermal oxide layer 206 and the chemical oxide layer 205 may also be desired. Therefore, the formed thermal oxide layer may be conducive to improving the properties of the interface between the fin structure 202 and the chemical oxide layer 205. Moreover, because a high-k dielectric layer may be subsequently formed on the surface of the chemical oxide layer 205, the presence of the chemical oxide layer 205 may be conducive to improving the properties of the high-k dielectric layer, and thus improve the condition at the interface between the chemical oxide layer and the high-k dielectric layer.

Therefore, in one embodiment, the thermal oxide layer 206 as well as the chemical oxide layer 205 formed on the surface of the thermal oxide layer 206 may together serve as an interfacial layer. As such, in addition to improving the properties of the interface between the base structure and the interfacial layer, the fabrication method may also improve the properties of the interface between the interfacial layer and the subsequently-formed high-k dielectric layer, and thus improve the performance of the subsequently-formed high-k dielectric layer.

The thermal oxide layer 206 may be made of SiOₓ. The thickness of the thermal oxide layer 206 may not be too small; otherwise, the thermal oxide layer 206 may not be thick enough to efficiently improve the properties of the interface between the fin structure 202 and the chemical oxide layer 205. The thickness of the thermal oxide layer 206 may not be too large either; otherwise, the interfacial layer may occupy an excessive portion of the gate dielectric layer and the oxide portion of the fin structure 202 may also be too thick. In one embodiment, the thickness of the thermal oxide layer 206 may be in a range of approximately 1 Å to 10 Å.

The annealing process may be a laser annealing process or a flash annealing process. The anneal temperature may be in a range of approximately 650 °C to 900 °C.

The annealing process may be performed in an annealing environment including O₂ and at least one of N₂, Ar, and He. In order to prevent an overly large thickness of the formed thermal oxide layer 206, the concentration of O₂ in the annealing environment may be relatively low. In one embodiment, the volume concentration of O₂ used in the annealing process may be in a range of approximately 1 ppm to 10 ppm.

In other embodiments, the interfacial layer may have a single layer structure containing only the thermal oxide layer.

Further, returning to FIG. 13, a high-k dielectric layer may be formed on the bottom and the sidewall surfaces of each opening in the NMOS region and the PMOS region (S404). FIG. 4 illustrates a schematic cross-section view of a corresponding semiconductor structure.

Referring to FIG. 4, a high-k dielectric layer 100 may be formed on the bottom and the sidewall surfaces of the opening 210 in the NMOS region I. In one embodiment, the semiconductor device to be formed also includes a PMOS region II, and accordingly, the high-k dielectric layer 100 may also be formed on the bottom and sidewall surfaces of the opening 220 in the PMOS region II. The high-k dielectric layer 100 may be formed on the surfaces of the interfacial layers as well as the top surface of the interlayer dielectric layer 204. The high-k dielectric layer 100 may be formed across the fin structure 202 in the opening 210 of the NMOS region I and also across the fin structure 202 in the opening 220 of the PMOS region II.

The high-k dielectric layer 100 may be made of a high-k dielectric material. The high-k dielectric material may refer to dielectric materials with a dielectric constant greater than that of SiO₂. Specifically, the high-k dielectric layer 100 may be made of HfO₂, HfSiO, HfSiON, HfTaO, HfTiO, HfZrO, ZrO₂, Al₂O₃, etc.

The high-k dielectric layer 100 may be formed by a process including chemical vapor deposition (CVD), physical vapor deposition (PVD), or atomic layer deposition (ALD). In one embodiment, the high-k dielectric layer 100 is made of HfO₂. The high-k dielectric layer 100 is formed by an ALD process. The thickness of the high-k dielectric layer 100 is in a range of approximately 5 Å to 15 Å.

The high-k dielectric layer 100 may be formed on the surface of the chemical oxide layer 205 such that a mixed structure of Hf-Si-O may be easily formed at the interface between the chemical oxide layer 205 and the high-k dielectric layer 100. Therefore, the interface state between the high-k dielectric layer 100 and the interfacial layer may be improved and the formed high-k dielectric layer may have desired quality.

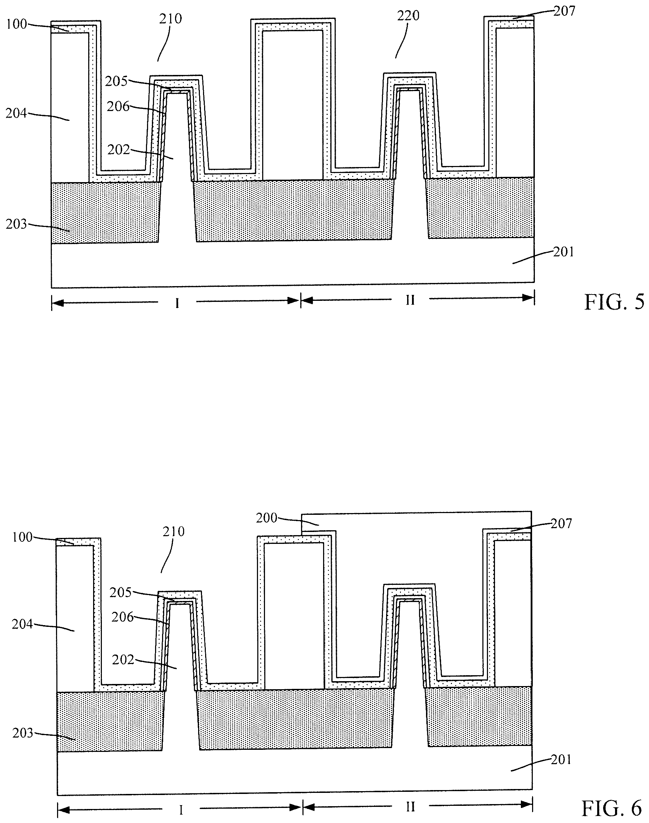

Further, returning to FIG. 13, a first work function layer may be formed on the high-k dielectric layer (S405). FIG. 5 illustrates a schematic cross-section view of a corresponding semiconductor structure.

Referring to FIG. 5, a first work function layer 207 may be formed on the high-k dielectric layer 100. In one embodiment, the first work function layer 207 may be formed on the high-k dielectric layer 100 in the opening 210 of the NMOS region I and also on the high-k dielectric layer 100 in the opening 220 of the PMOS region II.

The first work function layer 207 may be made of a P-type work function material. The portion of the first work function layer 207 formed in the opening 220 of the PMOS region II may serve as a portion of a subsequently-formed P-type work function layer. The work function value of the material used to form the first work function layer 207 may be in a range of approximately 5.1 eV to 5.5 eV, such as 5.2 eV, 5.3 eV, 5.4 eV, etc.

The first work function layer 207 may be made of TiN, TaN, TaSiN, or TiSiN. The first work function layer 207 may be formed by a process including CVD, PVD, or ALD. In one embodiment, the first work function layer 207 is made of TiN and the thickness of the first work function layer 207 is in a range of approximately 15 Å to 40 Å.

Further, returning to FIG. 13, the portion of the first work function layer formed in the opening of the NMOS region may be removed to expose the surface of the high-k dielectric layer in the opening of the NMOS region (S406). FIG. 6 illustrates a schematic cross-section view of a corresponding semiconductor structure.

Referring to FIG. 6, an etching process may be performed to remove the portion of the first work function layer 207 formed in the opening 210 of the NMOS region I. After etching, the surface of the high-k dielectric layer 100 may be exposed in the opening 210 of the NMOS region I.

Specifically, the portion of the first work function layer 207 in the opening 210 of the NMOS region may be removed by a process including the following steps. A filler layer 200 may be formed in the opening 220 of the PMOS region II. The filler layer 200 may cover the PMOS region II. The portion of the first work function layer 207 formed in the opening 210 of the NMOS region I may then be removed by etching using the filler layer 200 as an etch mask. The etching process may also remove the portion of the first work function layer 207 formed above the interlayer dielectric layer 204 of the NMOS region I. Further, the filler layer 200 may be removed.

The filler layer 200 may be an organic dielectric layer (ODL), a bottom anti-reflective coating (BARC) layer, or a deep ultraviolet-light absorbing oxide (DUO) layer. That is, the filler layer 200 may be made of a material such as organic dielectric material, BARC material, DUO material, etc. The filler layer 200 may be formed by a spin coating process. The DUO material is a silicone polymer including CH₃-SiOₓ, Si-OH, SiOH₃, etc. The filler layer 200 may be removed by an ashing process.

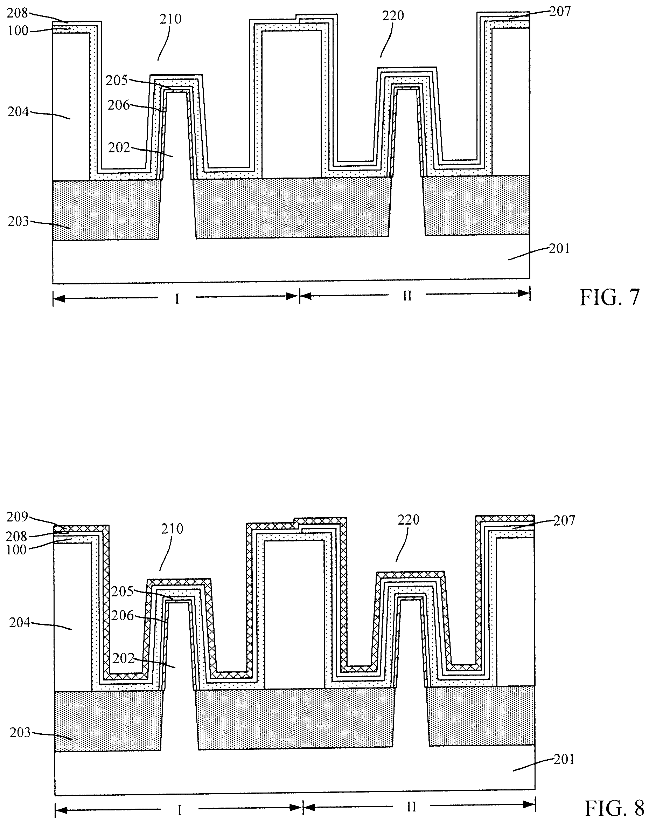

Returning to FIG. 13, a second work function layer may be formed on the high-k dielectric layer in the opening of the NMOS region and also on the portion of the first work function layer in the opening of the PMOS region (S407). FIG. 7 illustrates a schematic cross-section view of a corresponding semiconductor structure.

Referring to FIG. 7, a second work function layer 208 may be formed on the high-k dielectric layer 100 exposed in the opening 210 of the NMOS region I and also on the first work function layer 207 in the opening 220 of the PMOS region II.

The portion of the second work function layer 208 formed in the opening 210 of the NMOS region I may serve as a protective layer. The protective layer, i.e. the second work function layer 208, may be made of TiN or TaN. The thickness of the protective layer may be in a range of approximately 15 Å to 70Å. The portion of the second work function layer 208 as well as the first work function layer 207 formed in the opening 220 of the PMOS region II may serve as a P-type work function layer in the opening 220 of the PMOS region II. The P-type work function layer may be formed on the portion of the high-k dielectric layer 100 in the opening 220 of the PMOS region II.

The portion of the second work function layer 208 in the opening 210 of the NMOS region I may provide protection for the high-k dielectric layer 100 formed in the opening 210 of the NMOS region I, and thus prevent the Al ions in a subsequently-formed N-type work function layer from diffusing into the high-k dielectric layer 100. The portion of the second work function layer 208 and the portion of the first work function layer 202 formed in the opening 220 of the PMOS region may together play a regulatory role for the threshold voltage of the PMOS device. The second work function layer 208 may be made of a P-type work function material. For example, the second work function layer 208 may be made of TiN or TaN.

In one embodiment, the second work function layer 208 is made of TiN and formed by an ALD process. The thickness of the second work function layer 208 is in a range of approximately 15 Å to 70 Å.

In other embodiments, the portion of the second work function layer formed in the NMOS region I may be removed by an etching process.

Returning to FIG. 13, an N-type work function layer containing Al ions may be formed on the high-k dielectric layer in the NMOS region (S408). FIG. 8 illustrates a schematic cross-section view of a corresponding semiconductor structure.

Referring to FIG. 8, an N-type work function layer 209 may be formed on the portion of the high-k dielectric layer 100 in the NMOS region I. The N-type work function layer may contain Al ions.

In one embodiment, because of the presence of the protective layer (i.e., the second work function layer 208) on the portion of the high-k dielectric layer 100 formed in the NMOS region I, the N-type work function layer 209 may be formed on the surface of the protective layer in the NMOS region I. During the process to form the N-type work function layer 209 on the protective layer, the N-type work function layer 209 may also be formed on the P-type work function layer.

The N-type work function layer 209 may be made of an N-type work function material. The work function value of the N-type work function material may be in a range of approximately 3.9 eV to 4.5 eV, such as 4 eV, 4.1 eV, 4.3 eV and etc.

The N-type work function layer 209 may be formed by a process including CVD, PVD, or ALD. The N-type work functions layer 209 may be made of one or more from TiAl, TiAlN, TiAlC, AlN, etc.

In one embodiment, the N-type work function layer 209 is made of TiAlC. The thickness of the N-type work function layer is in a range of approximately 5 Å to 30 Å. The Al ions in the N-type work function layer 209 may have a mole percentage in a range of approximately 30% to 80%.

Because the threshold voltage of the PMOS transistor to be formed is mainly determined by the first work function layer 207 and the second work function layer 208, in order to save processing steps, during the fabrication process, the N-type work function layer 209 formed on the P-type work function layer may not be removed. When the N-type work function layer 209 formed on the P-type work function layer is retained, in order to substantially avoid the N-type work function layer in the PMOS region II causing undesired effects on the work function value, the thickness of the first work function layer and/or the thickness of the second work function layer may be properly increased to balance the influence of the N-type work function layer in the PMOS region II on the work function value.

In another embodiment, the N-type work function layer formed on the P-type work function layer may be removed through an etching process to prevent the Al ions in the N-type work function layer in the PMOS region from diffusing into the P-type work function layer during a subsequently-performed annealing process.

After forming the N-type work function layer 209 and prior to forming the diffusion barrier layer, an oxidation process may be performed on the N-type work function layer 209 to form a layer of alumina on the N-type work function layer 209. The alumina layer 209 may provide protection for the N-type work function layer 209, and thus prevent the ions in a subsequently-formed metal gate electrode from diffusing into the N-type work function layer 209.

Further, in order to avoid the alumina layer having undesired effects on the effective work function value of the gate structure in the NMOS transistor, the thickness of the alumina layer may not be too thick. In one embodiment, the thickness of the alumina layer is smaller than or equal to 5 Å.

The oxidation process may use a gas containing one or more of O₃, O₂, NO, and N₂O to treat the surface of the N-type work function layer 209. The oxidation process may also use oxygen plasma to treat the surface of the N-type work function layer 209.

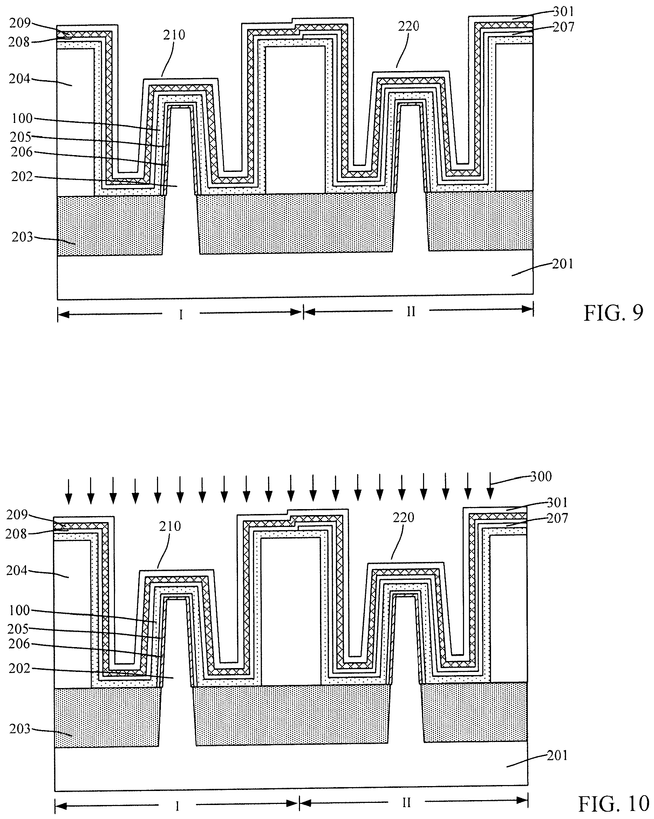

Further, returning to FIG. 13, a diffusion barrier layer may be formed on the N-type work function layer (S409). FIG. 9 illustrates a schematic cross-section view of a corresponding semiconductor structure.

Referring to FIG. 9, a diffusion barrier layer 301 may be formed on the N-type work function layer 209. The diffusion barrier layer 301 formed on the N-type work function layer 209 may be used to prevent the diffusible ions in a subsequently-formed metal gate electrode from diffusing into the N-type work function layer.

In one embodiment, besides being formed on the N-type work function layer in the opening 210 of the NMOS region I, the diffusion barrier layer 301 may also be formed on the N-type work function layer 209 in the opening 220 of the PMOS region II.

The diffusion barrier layer 301 may provide protection for the N-type work function 209, and thus prevent the diffusible ions in the subsequently-formed metal gate electrode from diffusing into the N-type work function layer 209. For example, the diffusion barrier layer 301 may prevent the fluorine ions in the metal gate electrode from diffusing into the N-type work function layer 209.

The diffusion barrier layer 301 may be formed by TiN or TaN. In one embodiment, the diffusion barrier layer 301 is made of TiN, and the thickness of the diffusion barrier layer 301 may be in a range of approximately 10 Å to 60 Å.

Further, returning to FIG. 13, a hydrogenation process may be performed on the diffusion barrier layer (S410). FIG. 10 illustrates a schematic diagram of performing a hydrogenation process consistent with various embodiments of the invention.

Referring to FIG. 10, a hydrogenation process 300 may be performed on the diffusion barrier layer 301. The hydrogenation process 300 may have the capability to increase the hydrogen concentration in the diffusion barrier layer 301. Therefore, after performing the hydrogenation process, the hydrogen concentration in the diffusion barrier layer 301 may be increased.

When the ability of the diffusion barrier layer 301 to prevent the ions in the metal gate electrode from diffusing into the N-type work function layer 209 is insufficient, ions in the metal gate electrode may diffuse into the N-type work function layer 209. Especially in a case where the thickness of the diffusion barrier layer 301 is relatively small, the ions in the metal gate electrode may more easily diffuse into the N-type work function layer 209 through the diffusion barrier layer 301.

Although the ions in the metal gate electrode that may easily diffuse may have a variety of species, as an example, fluorine ions are described as a primary source of diffusible ions. The fluorine ions may include both free fluorine ions and fluorine ion groups. In one embodiment, because the hydrogen concentration in the diffusion barrier layer 301 is enhanced through the hydrogenation process, the hydrogen ions in the diffusion barrier layer 301 may form chemical bonds with the fluorine ions. Therefore, the quantity of free fluorine ions may be significantly reduced, preventing the fluorine ions from diffusing into the N-type work function layer 209.

Specifically, a portion of the hydrogen ions may react with free fluorine ions or fluorine ion groups and form a gas. The gas generated due to the reaction may contain HF, and thus fluorine ions may be released from the diffusion barrier layer 301 as the gas is released.

Therefore, after performing the hydrogenation process 300, the ability of the diffusion barrier layer 301 to block ion diffusion from the metal gate electrode may be significantly improved. As such, the thickness of the diffusion barrier layer 301 may not need to be increased in order to improve the performance in blocking ion diffusion. Accordingly, the subsequent formation of the metal gate electrode may have a relatively large process window, which may further improve the filling ability of the metal gate electrode. Moreover, the disclosed fabrication method may reduce the required thickness of the diffusion barrier layer 301, and in the meantime, the diffusion barrier layer 301 may still have sufficient ability to block diffusion of the ions from the metal gate electrode. That is, even in a case where the thickness of the diffusion barrier layer 301 is relatively small, the diffusion barrier layer 301 may still demonstrate sufficient ability to block ion diffusion. Therefore, the occupied volume of the diffusion barrier layer 301 in the gate structure of the formed NMOS transistor may be reduced, which may further reduce the adverse effect of the diffusion barrier layer 301 on the effective work function value of the gate structure in the NMOS transistor.

In one embodiment, the hydrogenation process 300 may be an annealing process and the annealing process may be performed in an environmental gas containing H₂ or D₂. Because deuterium (D) is an isotope of hydrogen (H), D ions may demonstrate the same ability as H ions in terms of passivating fluorine ions.

Further, the anneal temperature during the annealing process may not be too low or too high. When the anneal temperature is too low, the concentration of hydrogen ions entering the diffusion barrier layer 301 may be too small. However, when the anneal temperature of the annealing process is too high, the Al ions in the N-type work function layer 209 may easily diffuse into the high-k dielectric layer 100. In one embodiment, the anneal temperature during the annealing process is kept in a range of approximately 100 Å to 500 Å.

In other embodiments, the hydrogenation process may also be a hydrogen ion implantation process. When the implantation depth during the hydrogen ion implantation process is too small, the increase in the hydrogen concentration in the diffusion barrier layer may be limited. However, when the implantation depth during the hydrogen ion implantation process is too large, the hydrogen ions may be easily implanted into the N-type work function layer. Therefore, during the hydrogen ion implantation process, the implantation depth may be approximately 1/3 to 2/3 of the entire thickness of the diffusion barrier layer.

In order to ensure desired ability of the diffusion barrier layer in blocking ion diffusion from the metal gate electrode and also avoid adverse effects on the effective work function value of the gate structure of the NMOS transistor due to an overly high concentration of the hydrogen ions, the implantation dose during the ion implantation process may not be too large or too small. In one embodiment, the implantation dose used the hydrogen ion implantation process may be in a range of approximately 1E14 atom/cm² to 3E16 atom/cm².

In other embodiments, the hydrogenation process may also use hydrogen plasma to treat the diffusion barrier layer 301. Further, in order to ensure the ability to block ion diffusion and prevent hydrogen ions from diffusing into the N-type work function layer, the process parameters of the hydrogen plasma treatment may include a chamber pressure in a range of approximately 1 Torr to 100 Torr and a chamber temperature smaller than or equal to 200 °C.

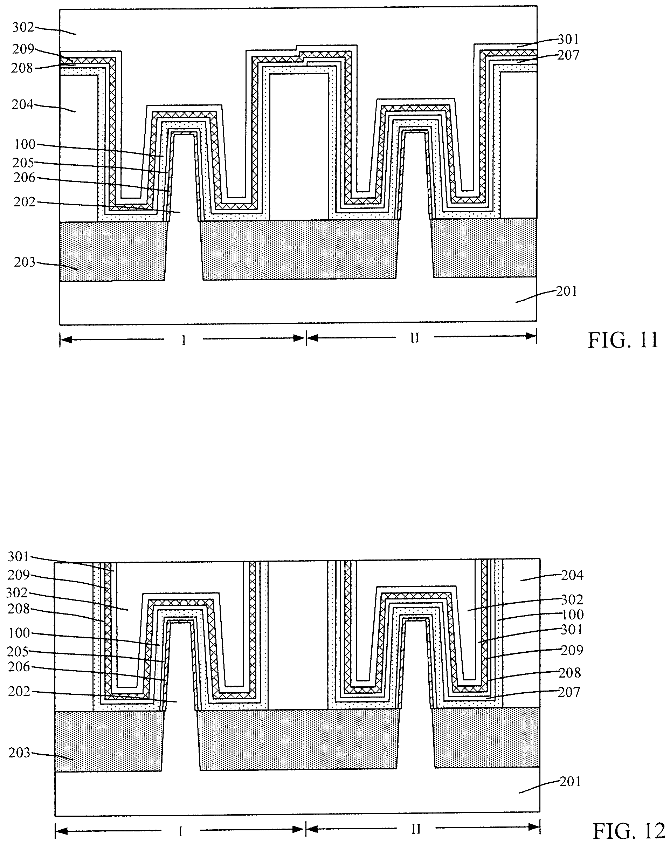

Further, returning to FIG. 13, a metal gate electrode may be formed on the diffusion barrier layer to fill up the opening in the NMOS region (S411). FIG. 11 illustrates a schematic cross-section view of a corresponding semiconductor structure.

Referring to FIG. 11, a metal gate electrode 302 may be formed on the diffusion barrier layer 301 after the hydrogenation process and filling up the opening 210 (referring to FIG. 10) in the NMOS region I. In one embodiment, when forming the metal gate electrode 302 to fill the opening 210 in the NMOS region I, the opening 220 (referring to FIG. 10) in the PMOS region II may be simultaneously filled with a metal gate electrode 302. The metal gate electrode 302 formed in the opening 220 of the PMOS region II may be electrically isolated from the metal gate electrode 302 formed in the opening 210 in the NMOS region I. Moreover, the metal gate electrode 302 formed in the opening 220 of the PMOS region II and the metal gate electrode 302 formed in the opening 210 in the NMOS region I may be made of a same material.

The metal gate electrode 302 may contain fluorine ions. In one embodiment, the metal gate electrode 302 is made of W. A source material used to form the metal gate electrode 302 may include WF₆. Accordingly, the formed metal gate electrode 302 may contain fluorine ions. In one embodiment, the metal gate electrode 302 may be formed by a CVD process.

Returning to FIG. 13, the portion of the metal gate electrode, the diffusion barrier layer, the N-type work function layer, the second work function layer, the first work function layer, and the high-k dielectric layer formed above the top surface of the interlayer dielectric layer may be removed (S412). FIG. 12 illustrates a schematic cross-section view of a corresponding semiconductor structure.

Referring to FIG. 12, the portion of the metal gate electrode 302, the diffusion barrier layer 301, the N-type work function layer 209, the second work function layer 208, the first work function layer 207, and the high-k dielectric layer 100 that are formed above the top surface of the interlayer dielectric layer 204 may be removed.

Moreover, the high-k dielectric layer 100, the second work function layer 208, the N-type work function layer 209, the diffusion barrier layer 301, and the metal gate electrode 302 formed in each opening 210 (referring to FIG. 10) of the NMOS region I may together form a first gate structure. Similarly, the high-k dielectric layer 100, the first work function layer 207, the second work function layer 208, the N-type work function layer 209, the diffusion barrier layer 301, and the metal gate electrode 302 formed in each opening 220 (referring to FIG. 10) of the PMOS region II may together form a second gate structure.

According to the fabrication method described above, in one embodiment, the diffusion barrier layer 301 demonstrates strong ability in blocking the diffusion of the fluorine ions in the metal gate electrode 302, and thus efficiently prevents the fluorine ions in the metal gate electrode 302 from diffusing into the N-type work function layer 209. Therefore, effects of the fluorine ions on the work function value of the N-type work function layer 209 may be avoided. That is, the fluorine ions may not affect the work function value of the N-type work function layer 209. As such, without requiring an increase in the thickness of the diffusion barrier layer 301, the disclosed fabrication method may still be able to improve the ability of the diffusion barrier layer in blocking the diffusion of the fluorine ions. Therefore, undesired effects on the effective work function value due to an overly large thickness of the diffusion barrier layer 301 may be avoided, and in addition, the metal gate electrode 302 may be ensured to demonstrate desired filling ability.

Moreover, in one embodiment, the semiconductor device to be formed is a CMOS device. In other embodiments, the semiconductor device may be a device other than CMOS device. For example, when the semiconductor device to be formed is an NMOS device including a plurality of NMOS transistors, the fabrication process for the semiconductor device may include forming a high-k dielectric layer on the bottom and the sidewall surfaces of the opening in the NMOS region, forming an N-type work function layer on the high-k dielectric layer, forming a diffusion barrier layer on the N-type work function layer, performing a hydrogenation process on the diffusion barrier layer, and after performing the hydrogenation process, forming a metal gate electrode on the diffusion barrier layer to fill up the opening in the NMOS region.

The present invention also provides a semiconductor structure corresponding to the fabrication method described above. FIG. 12 illustrates a schematic cross-section view of a corresponding semiconductor structure consistent with various embodiments of the present invention.

Referring to FIG. 12, the semiconductor structure may include a base structure including an NMOS region I. An interlayer dielectric layer 204 may be formed on the base structure. Moreover, the semiconductor structure may include a plurality of NMOS transistors formed in the NMOS region I. To form the NMOS transistors, a plurality of openings may be formed through the entire thickness of the interlayer dielectric layer 204 in the NMOS region I, and then an NMOS transistor may be formed in each opening of the NMOS region I. For illustration purpose, FIG. 12 shows only one NMOS transistor formed in the NMOS region I of the semiconductor structure.

Corresponding to each NMOS transistor formed in the NMOS region I, the semiconductor structure may include a high-k dielectric layer 100 formed on the bottom and the sidewall surfaces of the opening in the NMOS region I, an N-type work function layer 209 formed on the high-k dielectric layer 100, a diffusion barrier layer 301 formed on the N-type work function layer 209 through a hydrogenation process, and a metal gate electrode 302 formed on the diffusion barrier layer 301 and filling up the opening in the NMOS region I.

In one embodiment, the base structure may include a substrate 201 and a plurality fin structures 202 formed on the substrate 201. Further, the opening corresponding to each NMOS transistor may be formed across a fin structure 201 and expose a portion of the top and the side surfaces of the fin structure 202. The base structure may also include an isolation layer 203 formed on the surface of the substrate 201. The isolation layer 203 may cover a portion of the side surfaces of each fin structure 202, and the top surface of the isolation layer 203 may be lower than the top surfaces of the fin structures 202.

In one embodiment, the semiconductor structure may include a plurality of CMOS devices and the base structure may also include a PMOS region II. Accordingly, the semiconductor structure may further include a plurality of PMOS transistors formed in the PMOS region II. To form the PMOS transistors, a plurality of openings may be formed through the entire thickness of the interlayer dielectric layer 204 in the PMOS region II, and then a PMOS transistor may be formed in each opening in the PMOS region II. For illustration purpose, FIG. 12 shows only one PMOS transistor formed in the PMOS region II of the semiconductor structure. In addition, the high-k dielectric layer 100 may also be formed on the bottom and the sidewall surfaces of each opening in the PMOS region II.

Further, each PMOS transistor may further include a first work function layer 207 formed on the high-k dielectric layer 100, and a second work function layer 208 formed on the first work function layer 207. Therefore, corresponding to each PMOS transistor formed in the PMOS region II, the semiconductor structure may include a high-k dielectric layer 100 formed on the bottom and the sidewall surfaces of the opening in the PMOS region II, a first work function layer 207 formed on the high-k dielectric layer 100, a second work function layer 208 formed on the first work function layer 207, an N-type work function layer 209 formed on second work function layer 208, a diffusion barrier layer 301 formed on the N-type work function layer 209 through a hydrogenation process, and a metal gate electrode 302 formed on the diffusion barrier layer 301 and filling up the opening in the PMOS region II.

Because the threshold voltage of the PMOS transistor is mainly determined by the first work function layer 207 and the second work function layer 208, in order to save processing steps, during the fabrication process, the N-type work function layer 209 formed on the P-type work function layer may not be removed. When the N-type work function layer 209 formed on the P-type work function layer is retained, in order to substantially avoid the N-type work function layer in the PMOS region II causing undesired effects on the work function value, the thickness of the first work function layer and/or the thickness of the second work function layer may be properly increased to balance the influence of the N-type work function layer in the PMOS region II on the work function value.

In another embodiment, the N-type work function layer formed on the P-type work function layer may be removed through an etching process to prevent the Al ions in the N-type work function layer in the PMOS region from diffusing into the P-type work function layer during a subsequently-performed annealing process.

In one embodiment, the second work function layer 208 may also be formed in the NMOS transistors of the NMOS region I. Specifically, the second work function layer 208 may be formed between the diffusion barrier layer 301 and the high-k dielectric layer 100. As such, the second work function layer 208 may provide protection for the high-k dielectric layer 100 formed in the NMOS transistor of the NMOS region I.

The diffusion barrier layer 301 may be used to prevent the diffusible ions in the metal gate electrode 302 from diffusing into the N-type work function layer 209. In one embodiment, the diffusion barrier layer 301 may be made of hydrogen-containing TiN or hydrogen-containing TaN. Moreover, the diffusion barrier layer 301 in the semiconductor structure may have experienced the hydrogenation process described above such that the hydrogen concentration in the diffusion barrier layer 301 may be relatively high. Therefore, the ability of the diffusion barrier layer 301 to block the diffusion of the ions in the metal gate electrode 302 may be significantly improved. As such, even in a case where the thickness of the diffusion barrier layer 301 is relatively small, the diffusion barrier layer 301 may still demonstrate sufficient ability to block ion diffusion. Therefore, the occupied volume of the diffusion barrier layer 301 in the gate structure of the formed NMOS transistor may be reduced, which may further reduce the adverse effect of the diffusion barrier layer 301 on the effective work function value of the gate structure in the NMOS transistor.

In one embodiment, the metal gate electrode 302 may also be formed on the P-type work function layer and filling up each opening in the PMOS region II.

Compared to existing fabrication methods and semiconductor structures, the disclosed fabrication methods and semiconductor structures may demonstrate several advantages.

According to the disclosed fabrication methods, after consecutively forming a high-k dielectric layer, an N-type work function layer, and a diffusion barrier layer in the openings formed in the NMOS region, a hydrogenation process is then performed on the diffusion barrier layer to increase the hydrogen concentration in the diffusion barrier layer. After further forming a metal gate electrode on the diffusion barrier layer to fill up each opening in the NMOS region, the diffusible ions in the metal gate electrode may diffuse into the diffusion barrier layer. Moreover, the hydrogen ions in the diffusion barrier layer may easily react with the ions diffused into the diffusion barrier layer, preventing the diffusible ions from further diffusing into the N-type work function layer. Therefore, the disclosed fabrication method and semiconductor structure may improve the ability of the diffusion barrier layer to protect the N-type work function layer. As such, increasing the thickness of the diffusion barrier layer may become unnecessary for improving the protection provided by the diffusion barrier layer. Accordingly, the disclosed method and semiconductor structure may also improve the filling ability for the process to form the metal gate electrode, and thus improve the electrical performance of the formed semiconductor device.

Further, according to the disclosed fabrication methods, the hydrogenation process may be an annealing process. The anneal temperature adopted in the annealing process may be in a range of approximately 100 °C to 500 °C. The moderate anneal temperature may ensure that after hydrogen ions entering the diffusion barrier layer during the annealing process, the hydrogen concentration in the diffusion barrier layer may be moderate, and thus prevent the hydrogen ions from diffusing into the N-type work function layer through the diffusion barrier layer.

Moreover, the hydrogenation process may also be a hydrogen ion implantation process. The implantation depth may be approximately 1/3 to 2/3 of the thickness of the diffusion barrier layer in order to prevent the hydrogen ions from diffusing into the N-type work function layer.

## Claims

1. A method for fabricating a semiconductor structure, comprising:
providing a base structure including an N-type metal-oxide-semiconductor (NMOS) region;
forming an interlayer dielectric layer on the base structure with a plurality of openings formed in the NMOS region through the interlayer dielectric layer;
forming a high-k dielectric layer on a bottom and sidewall surfaces of each opening of the NMOS region;
forming an N-type work function layer on the high-k dielectric layer in each opening of the NMOS region;
forming a diffusion barrier layer on the N-type work function layer;
performing a hydrogenation process on the diffusion barrier layer; and
forming a metal gate electrode on the diffusion barrier layer to fill up each opening in the NMOS region.

2. The method for fabricating the semiconductor structure according to claim 1, wherein:
the metal gate electrode contains fluorine ions.

3. The method for fabricating the semiconductor structure according to claim 1 or 2, wherein:
the hydrogenation process includes an annealing process; and
an environmental gas of H2 or D2 is used in the annealing process; and
wherein preferably, an anneal temperature used in the annealing process is in a range of approximately 100 °C to 500 °C.

4. The method for fabricating the semiconductor structure according to anyone of the claims 1-3, wherein:
the hydrogenation process is a hydrogen ion implantation process.

5. The method for fabricating the semiconductor structure according to claim 4, wherein:
an implantation depth of the hydrogen ion implantation process is approximately 1/3 to 2/3 of a thickness of the diffusion barrier layer; and
an implantation dose during the hydrogen ion implantation process is in a range of approximately 1E14 atom/cm2 to 3E16 atom/cm2.

6. The method for fabricating the semiconductor structure according to anyone of the claims 1-5, wherein:
the hydrogenation process includes using hydrogen plasma to treat the diffusion barrier layer.

7. The method for fabricating the semiconductor structure according to claim 6, wherein the hydrogen plasma treatment uses process parameters including:
a treatment chamber pressure in a range of approximately 1 Torr to 100 Torr; and
a treatment chamber temperature smaller than or equal to 200 °C.

8. The method for fabricating the semiconductor structure according to anyone of the claims 1-7, wherein:
the diffusion barrier layer is made of one or more of TiN and TaN, and the N-type work function layer is made of at least one of TiAl, TiAlN, TiAlC, and AlN; and/or
a thickness of the diffusion barrier layer is in a range of approximately 10 Å to 60 Å.

9. The method for fabricating the semiconductor structure according to anyone of the claims 1-8, prior to forming the diffusion barrier layer, further including:
performing an oxygenation process on the N-type work function layer to form an alumina layer on the N-type work function layer.

10. The method for fabricating the semiconductor structure according to anyone of the claims 1-9, wherein the base structure further includes a P-type metal-oxide-semiconductor (PMOS) region, and the method further includes:
forming a plurality of openings in the PMOS region through the interlayer dielectric layer;
forming a high-k dielectric layer on a bottom and sidewall surfaces of each opening in the PMOS region;
forming a P-type work function layer above the high-k dielectric layer in each opening of the PMOS region; and
forming a metal gate electrode on the P-type work function layer to fill up each opening in the PMOS region.

11. The method for fabricating the semiconductor structure according to claim 10, wherein forming the high-k dielectric layer, the P-type work function layer, the diffusion barrier layer, the N-type work function layer, and the metal gate electrode includes:
forming a high-k dielectric layer on the bottom and the sidewall surfaces of each opening in the NMOS region and also on the bottom and the sidewall surfaces of each opening in the PMOS region;
forming a first work function layer on the high-k dielectric layer;
removing the portion of the first work function layer formed in each opening of the NMOS region to expose a portion of the high-k dielectric layer in the opening;
forming a second work function layer on the portion of the first work function layer in each opening of the PMOS region, wherein the portion of the second work function layer and the portion of the first work function layer formed in the opening of the PMOS region together serve as the P-type work function layer;
forming the N-type work function layer on the portion of the high-k dielectric layer exposed in each opening of the NMOS region;
forming the diffusion barrier layer on the N-type work function layer; and
after performing the hydrogenation process on the diffusion barrier layer, forming a metal gate electrode to fill each opening in the NMOS region or in the PMOS region.

12. The method for fabricating the semiconductor structure according to claim 10 or 11, wherein:
the second work function layer is also formed above the high-k dielectric layer in each opening of the NMOS region to protect the portion of the high-k dielectric layer in each opening of the NMOS region;
the N-type work function layer is formed on a top surface of the second work function layer; and
the N-type work function is also above the P-type work function layer.

13. The method for fabricating the semiconductor structure according to anyone of the claim 10-12, wherein:
the first work function layer is made of one or more of TiN, TaN, TaSiN, and TiSiN, and the second work function layer is made of one or more of TiN and TaN; and/or
a thickness of the first work function layer is in a range of approximately 15 Å to 40 Å, and a thickness of the second work function layer is in a range of approximately 15 Å to 70 Å.

14. A semiconductor structure, comprising:
a base structure including an NMOS region, wherein an interlayer dielectric layer is formed on the base structure with a plurality of openings formed in the NMOS region through the interlayer dielectric layer;
a high-k dielectric layer formed on a bottom and sidewall surfaces of each opening of the NMOS region;
an N-type work function layer formed on the high-k dielectric layer in each opening of the NMOS region;
a diffusion barrier layer formed on the N-type work function layer, and hydrogenated through a hydrogenation process; and
a metal gate electrode formed on the hydrogenated diffusion barrier layer to fill up each opening in the NMOS region.

15. The semiconductor structure according to claim 14, wherein at least one of:
the hydrogenated diffusion barrier layer is made of hydrogen-containing TiN or hydrogen-containing TaN;
a thickness of the diffusion barrier layer is in a range of approximately 10 Å to 60 Å; and
the base structure further includes a P-type metal-oxide-semiconductor (PMOS) region, the interlayer dielectric layer further includes a plurality of openings there-through and formed in the PMOS region; a high-k dielectric layer is formed on a bottom and sidewall surfaces of each opening in the PMOS region; a P-type work function layer is formed above the high-k dielectric layer in each opening of the PMOS region; and a metal gate electrode is formed on the P-type work function layer to fill up each opening in the PMOS region.
